(19) **Europäisches Patentamt / European Patent Office / Office européen des brevets**

(11) **EP 2 173 031 B1**

(12) **EUROPEAN PATENT SPECIFICATION**

(45) Date of publication and mention
of the grant of the patent:
**06.06.2012 Bulletin 2012/23**

(51) Int Cl.:
*H03F 1/26* (2006.01)       *H03F 3/00* (2006.01)
*H03F 3/45* (2006.01)

(21) Application number: **08017310.7**

(22) Date of filing: **01.10.2008**

(54) **Amplifier arrangement, measurement arrangement and signal processing method**

Verstärkeranordnung, Messanordnung und Signalverarbeitungsverfahren

Agencement d'amplificateur, agencement de mesure et procédé de traitement de signal

(84) Designated Contracting States:
**AT BE BG CH CY CZ DE DK EE ES FI FR GB GR
HR HU IE IS IT LI LT LU LV MC MT NL NO PL PT
RO SE SI SK TR**

(43) Date of publication of application:
**07.04.2010 Bulletin 2010/14**

(73) Proprietor: **Austriamicrosystems AG
8141 Unterpremstätten (AT)**

(72) Inventor: **Tiruvuru, Rajesh
Nagalapuram
517589 Andhra Pradesh (IN)**

(74) Representative: **Epping - Hermann - Fischer
Patentanwaltsgesellschaft mbH
Ridlerstrasse 55
80339 München (DE)**

(56) References cited:
**US-A- 5 136 255       US-A1- 2004 075 601
US-B1- 6 617 838**

- **CHOI Y ET AL: "SC Amplifier and SC Integrator
With an Accurate Gain of 2" IEEE
TRANSACTIONS ON CIRCUITS AND SYSTEMS II:
EXPRESS BRIEFS, IEEE SERVICE CENTER, NEW
YORK, NY, US, vol. 52, no. 4, 1 April 2005
(2005-04-01), pages 194-198, XP011129792 ISSN:
1057-7130**

## Description

The present invention relates to an amplifier arrangement which can be used for current sensing and to a measurement arrangement with such an amplifier arrangement. The present invention further relates to a signal processing method.

Recent applications in industrial and automotive fields often require precise measuring of current or voltage signals. Such results may then be used to calculate the actual signal voltage provided by a voltage source or the amount of current drawn by a device connected to a source. For instance, a precise measurement of a voltage provided by a battery source as well as the current drawn by the loads may be required in automotive applications.

Document US 5,498,984 presents a current sense amplifier typically used to measure an amount of current drawn from or supplied to a power supply in various types of electronic equipments. Document US 6,621,259 shows another circuit for measuring a bidirectional current across a current sense element.

Those documents teach a sense amplifier which, however, may have limited capabilities with respect to high-precision application measurements. For instance, the output signal may comprise an offset and/or low frequency noise generated in the sense amplifier itself.

Document US 6,617,838 B1 shows a current measurement circuit which has one differential signal path for receiving an input signal at a differential signal input, wherein said differential signal path is connected to a differential amplifier. A capacitor on each of the differential signal lines can be switched to one of the signal inputs and to one of the amplifier inputs.

Therefore, it is desirable to come up with an improved amplifier arrangement and with a measurement arrangement with such an amplifier arrangement. It can be furthermore desirable to provide an improved signal processing method for processing such signals.

These and other objects are solved by the subject matter of the present independent claims. Embodiments and developments of the invention are the subject matter of the dependent claims.

According to one embodiment of an amplifier arrangement, an amplifier with a differential input and a differential output is provided. Furthermore, a first and a second pair of charge stores are provided which can be connected to a differential signal input of the amplifier arrangement or to a high-side reference potential connection in a switchable fashion and further to the differential input of the amplifier or to a low-side reference potential connection, also in a switchable fashion. Herein, the switching is performed in a crossed fashion with respect to the first and the second pair of charge stores. In other words, one pair of charge stores is provided with a different polarity of the differential signal input compared to the other pair of charge stores. The differential output of the amplifier and differential input of the amplifier can be connected in a switchable fashion by means of a third and a fourth pair of charge stores which are preferably activated alternately. Therefore, a chopping modulation can be performed for an input signal at the differential signal input which enables removing of a possible offset and low frequency noise of the arrangement. For example, an amplifier arrangement comprises a first differential signal path coupling a differential signal input to the differential input of the amplifier, wherein the first differential signal path comprises the first pair of charge stores which are connected in between a first and a second pair of switches. The amplifier arrangement further comprises a second differential signal path coupling a differential signal input to the differential input of the amplifier in a crossed fashion with respect to the first differential signal path. Herein, the second differential signal path comprises a second pair of charge stores connected in between a third and a fourth pair of switches. A differential signal output of the amplifier arrangement is coupled to the differential output of the amplifier and, in a switchable manner, to the differential input of the amplifier by the third and the fourth pair of charge stores, respectively. Furthermore, respective first connections of the charge stores of the first and the second pair of charge stores are coupled to the high-side reference potential connection in a switchable manner, wherein respective second connections of the charge stores of the first and the second pair of charge stores are coupled to the low-side reference potential connection in a switchable manner.

The amplifier arrangement is configured, during a first period, to connect the first pair of charge stores between the differential signal input and the low-side reference potential connection. Furthermore, during the first period, the second pair of charge stores is connected between the high-side reference potential connection and the differential input of the amplifier while the differential input of the amplifier is connected to the differential output of the amplifier via the third pair of charge stores.

The amplifier arrangement is further configured to, during a second period, connect, in a crossed fashion, the second pair of charge stores between the differential signal input and the low-side reference potential connection. During the second period, the first pair of charge stores is connected between the high-side reference potential connection and the differential input of the amplifier, while the differential input of the amplifier is connected to the differential output of the amplifier via the fourth pair of charge stores.

The first and the second period are alternating and non-overlapping.

In a further embodiment, the amplifier arrangement is configured, during the first period, to discharge the charge stores of the fourth pair of the charge stores and, during the second period, to discharge the charge stores of the third pair of charge stores.

In various embodiments, the charge stores of the first and the second pair of charge stores have the same first capacitance value, while the charge stores of the third and fourth pair of charge stores have the same second capacitance value. Herein, the term "same value" is limited by production tolerances. In other words, the respective charge stores have nominally the same capacitance value. The first and second capacitance value can be the same or can differ from each other. For example, an input/output gain of the amplifier arrangement is determined by the ratio of first and second capacitance value.

Accordingly, in some embodiments, the first and/or the second capacitance value is adjustable. In this case, the gain of the amplifier arrangement can be adjusted or programmed respectively.

An embodiment of a measurement arrangement comprises an amplifier arrangement according to one of the embodiments described above. In this case, the amplifier arrangement is configured to be operated with switching signals based on a signal with a chopping frequency. The measurement arrangement further comprises an analog-to-digital converter which is coupled to the differential signal output of the amplifier arrangement. A digital dechopper is coupled to the analog-to-digital converter for dechopping digital values provided by the analog-to-digital converter as a function of the signal with the chopping frequency.

A signal to be measured by the measurement arrangement is first processed in the amplifier arrangement such that a chopped analog signal is generated representing the input signal and being based on the signal with the chopping frequency. In other words, respective switching signals for switches of the amplifier arrangement are derived from the signal with the chopping frequency. A duty cycle of the switching signals and/or clock edges of the switching signals can be different from the signal with the chopping frequency.

The chopped analog signal which, for example, has an alternating polarity is converted to a digital signal by the analog-to-digital converter. The digitized chopped signal is then processed in the digital dechopper such that a dechopped signal representing the input signal of the measurement arrangement is generated. As the dechopper accounts for a switching polarity of the differential output signal of the amplifier arrangement, an offset and low frequency noise of the signal path can be removed. Furthermore, the dechopping removes possible amplification gain differences between the two signal paths. Thus, the measurement accuracy of the measurement arrangement is improved.

For example, in one embodiment, the dechopper is configured to perform the dechopping by averaging the digital values provided by the analog-to-digital converter.

In an embodiment of a signal processing method, a differential input signal is provided at the differential signal input. During a first period, a first pair of charge stores is connected between a differential signal input and a low-side reference potential connection. Furthermore, during the first period, a second pair of charge stores is connected between a high-side reference potential connection and the differential input of an amplifier. The differential input of the amplifier is connected to a differential output of the amplifier via a third pair of charge stores during the first period. During a second period, the second pair of charge stores is connected between a differential signal input and the low-side reference potential connection in a crossed fashion with respect to the first pair of charge stores. The first pair of charge stores is connected between the high-side reference potential connection and the differential input of the amplifier during the second period. Furthermore, during the second period, the differential input of the amplifier is connected to the differential output of the amplifier via the fourth pair of charge stores. An output signal at the differential output of the amplifier is provided to a differential signal output.

By the alternate connection of the first and the second pair of charge stores and the amplifier, respectively, chopping of the input signal is performed during the first and the second period. First and second period are alternating and non-overlapping.

In one embodiment, during the first period, the charge stores of the fourth pair of charge stores are discharged, and, during the second period, the charge stores of the third pair of charge stores are discharged. Accordingly, the third and the fourth pair of charge stores have a predefined charging state when being charged depending on the charging state of the first and the second pair of charge stores, respectively. In particular, the third pair of charge stores is charged during the first period depending on a charging state of the second pair of charge stores, whereas the fourth pair of charge stores is charged during the second period depending on a charging state of the first pair of charge stores.

In one embodiment of the signal processing method, clocking signals are used which determine the first and the second period. In this case, the clocking signals are based on a signal with a chopping frequency. The output signal is analog-to-digital converted in this embodiment. Furthermore, digital values resulting from the analog-to-digital conversion are dechopped as a function of the signal with the dechopping frequency.

In one embodiment, the dechopping comprises averaging the digital values, wherein a sign of the digital values resulting from the chopping is considered during dechopping.

The text below explains the invention in detail using exemplary embodiments with reference to the drawings, in which:

FIG. 1    is an embodiment of an amplifier arrangement,

FIG. 2    is a timing diagram of switching signals for the amplifier arrangement,

FIG. 3    is an embodiment of a measurement arrangement,

FIG. 4    is an embodiment of a circuit for deriving a high-side reference potential, and

FIG. 5    is an embodiment of a circuit for deriving a low-side reference potential.

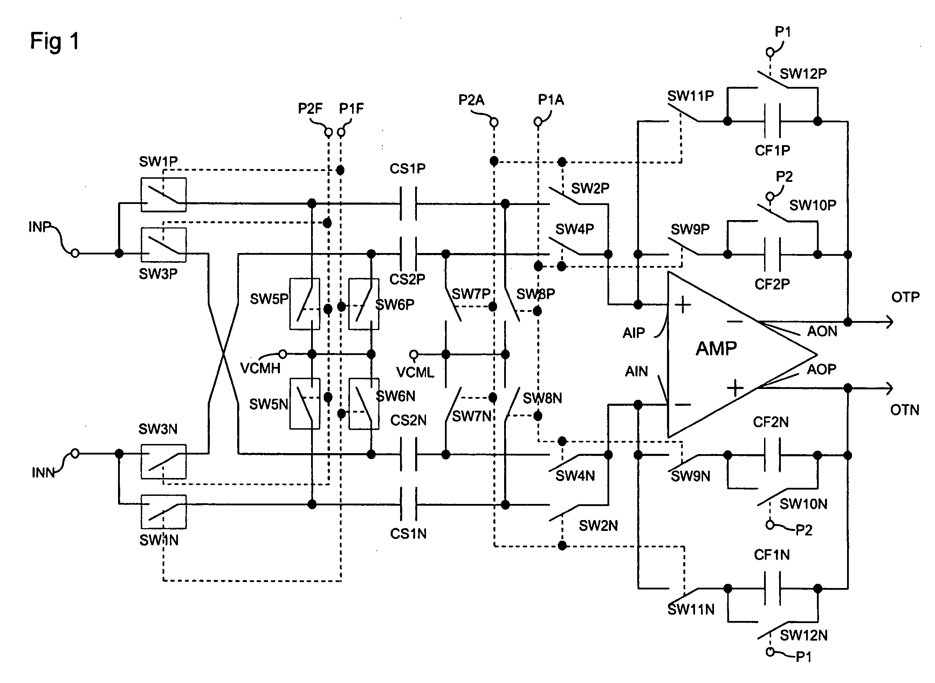

FIG. 1 shows an embodiment of an amplifier arrangement with a differential signal input INP, INN, an amplifier AMP and a differential signal output OTP, OTN. The amplifier AMP comprises a non-inverting input AIP and an inverting input AIN which together form a differential input AIP, AIN of the amplifier AMP. The amplifier AMP further comprises a non-inverting output AOP, which is coupled to the connection OTN of the differential signal output, and an inverting output AON which is coupled to the connection OTP of the differential signal output. The outputs AOP, AON form a differential output of the amplifier AMP.

The amplifier arrangement further comprises a first and a second pair of charge stores CS1P, CS1N, CS2P, CS2N. The charge store CS1P is coupled to the signal input connection INP via a switch SW1P and to the amplifier input connection AIP via a switch SW2P. Similarly, the charge store CS1N is coupled to the signal input connection INN via a switch SW1N and to the amplifier input connection AIN via a switch SW2N. The series connection of the switch SW1P, the charge store S1P and the switch SW2P together with the series connection of the switch SW1N, the charge store CS1N and the switch SW2N form a first differential signal path coupling a differential signal input INP, INN to the differential input AIP, AIN of the amplifier AMP.

The charge store CS2P is coupled to the signal input connection INN via a switch SW3N and to the amplifier input connection AIP via a switch SW4P. The charge store CS2N is coupled to the signal input connection INP via a switch SW3P and to the amplifier input connection AIN via a switch SW4N. In accordance with the first differential signal path, the series connections of elements SW3N, CS2P, SW4P and SW3P, CS2N, SW4N, respectively, form a second differential signal path. However, with respect to the first differential signal path, the second differential signal path couples the differential signal input INP, INN to a differential input AIP, AIN of the amplifier AMP in a crossed fashion.

First connections of the charge stores CS1P, CS1N, CS2P, CS2N are coupled to a high-side reference potential connection VCMH via respective switches SW5P, SW6P, SW5N, SW6N. Similarly, second connections of the charge stores CS1P, CS1N, CS2P, CS2N are coupled to a low-side reference potential connection VCML via switches SW7P, SW8P, SW7N, SW8N.

The amplifier arrangement further comprises a third and a fourth pair of charge stores CF2P, CF2N, CF1P, CF1N which couple the differential output AON, AOP of the amplifier AMP to its differential input AIP, AIN in a switchable manner. In particular, the amplifier output connection AON is coupled to the amplifier input connection AIP via respective series connections of charge store CF1P and a switch SW11P and of charge store CF2P and a switch SW9P, wherein the switches SW9P, SW11P are located at the input side of the amplifier AMP. In a similar fashion, the amplifier output connection AOP is connected to the amplifier input connection AIN via respective series connections of the charge store CF2N and a switch SW9N and of the charge store CF1N and a switch SW11N. Also for these series connections, the switches SW9N, SW11N are located at the input side of the amplifier AMP. Respective switches SW10P, SW12P, SW10N, SW12N are connected in parallel to the charge stores CF2P, CF1P, CF2N, CF1N.

The amplifier arrangement further comprises several input connections P1, P2, P1A, P2A, P1F, P2F for providing switching signals for the respective switches. In particular, respective control connections of the switches SW1P, SW6P, SW6N, SW1N are coupled to connection P1F, whereas control connections of the switches SW3P, SW3N, SW5P, SW5N are coupled to connection P2F. Control connections of the switches SW2P, SW2N, SW7P, SW7N, SW11P, SW11N are coupled to connection P2A, whereas control connections of the switches SW4P, SW4N, SW8P, SW8N, SW9P, SW9N are coupled to connection P1A; Control connections of the switches SW12P, SW12N are coupled to connection P1, whereas control connections of switches SW10P, SW10N are coupled to connection P2.

In some embodiments, MOS transistors are used for the switches. In this case, the use of PMOS transistors is preferred, whereas the use of NMOS transistors is also possible. PMOS switches can for example be used for the case where NMOS switches need gate voltages higher than what is available for turning on. This case can also be called a floating case.

In particular, the switches SW1P, SW1N, SW3P, SW3N, SW5P, SW5N, SW6P, SW6N, which are shown with a box around the switch symbol, preferably are floating PMOS switches working at a higher voltage potential. However, a voltage difference between source and drain during as well open as closed states is comparable or equal to conventional PMOS transistors. For considering the higher voltage potential at these switches, respective switching signals at connections P1F, P2F are level shifted. In other words, as well a high level and a low level of the switching signal is in the order of the higher voltage potential of the switches.

As can be seen from the arrangement of the first and the second pair of charge stores CS1P, CS1N, CS2P, CS2N, the third and the fourth pair of charge stores CF1P, CF1N, CF2P, CF2N and the control connections of the respective switches, the amplifier arrangement is operated in a fully differential fashion, as well at the input side of the amplifier AMP as at its output side.

A voltage provided at the high-side reference potential connection VCMH preferably is a voltage derived from respective potentials at the connections INP, INN of the differential signal input of the arrangement. For example, said voltage is a common mode voltage having a value in between the respective potentials at the connections INP, INN. Taken absolutely, the voltage at the high-side reference potential connection VCMH can be relatively high, for example some tens of Volts, compared to the relative voltages, for example 3.3 or 5 Volts, arising at the respective switches coupled to the connection VCMH.

In a similar fashion, a voltage provided at the low-side reference potential connection VCML is a voltage in the order of a supply voltage of the amplifier AMP. For example, said voltage is a common mode voltage derived from a positive supply voltage and a negative supply voltage of the amplifier. Accordingly, the voltage at the low-side reference potential connection VCML is usually lower than the voltage at the high-side reference potential connection VCMH.

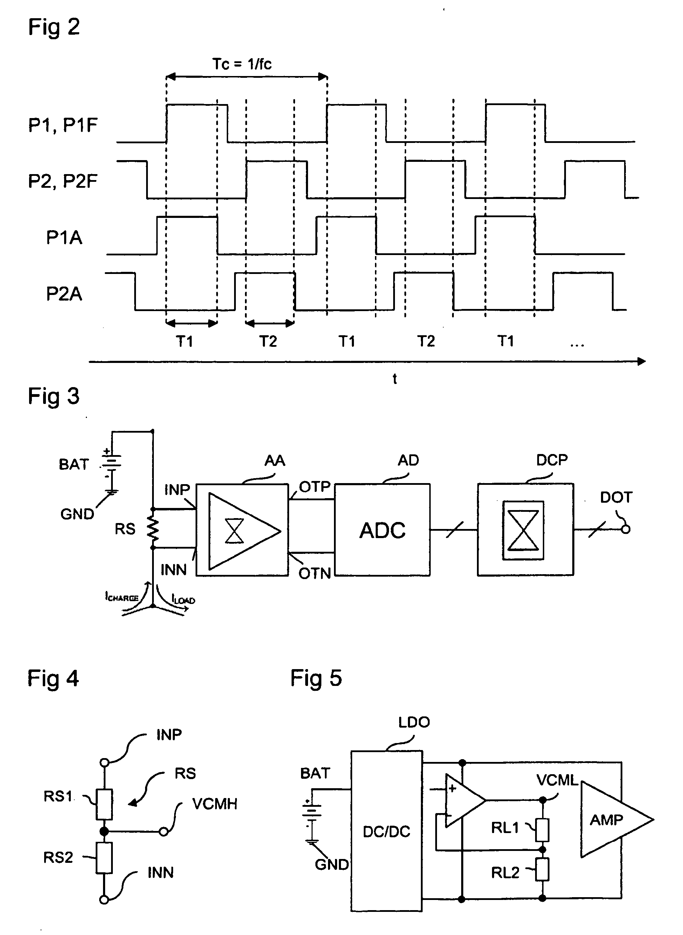

Operation of the amplifier arrangement shown in FIG. 1 is further explained in conjunction with the timing diagram of switching signals shown in FIG. 2 which are to be provided to the amplifier arrangement.

As can be seen from FIG. 2, the switching signals at P1, P1F and at P2, P2F have respective same logic levels. With reference to the description given above, the switches controlled by switching signals at P1F, P2F are operated at higher voltages or, at least, at voltages different from voltages at the switches controlled by the switching signals at P1, P2. Accordingly, the switching signals at P1, P2 differ from the switching signals at P1F, P2F only by their absolute signal level. The switching signals at P1A, P2A are time shifted versions of the switching signals at P1, P2. Switching signals at P1, respectively P1F, and at P2, respectively P2F, are non-overlapping with respect to their high level. Accordingly, also the switching signals at P1A and P2A are non-overlapping with respect to their high level. The switches are controlled such that they are in a closed state for a high level of the respective switching signal.

For example, the switching signals have a switching period Tc which depends on a chopping frequency fc. In this case, a reference signal with a chopping frequency fc can be provided for generating the switching signals shown in FIG. 2. The provision of the signal with the chopping frequency and the generation of the respective switching signals is not shown here as being understood without further explanation by a skilled person.

The high levels of the switching signals at P1, P1F and P1A form a first period T1, whereas high levels of the switching signals at P2, P2F and P2A form a second period. As the respective switching signals are non-overlapping, also the first and the second period T1, T2 are non-overlapping. Furthermore, first and second periods T1, T2 are alternating.

With reference to FIG. 1, during the first period T1, the first pair of charge stores CS1P, CS1N is connected between a different signal input INP, INN and the low-side reference potential connection VCML. Accordingly, the charge store CS1P is charged to a voltage being basically equal to the voltage difference between the potential at the input connection INP and the low-side reference potential connection VCML. Furthermore, the charge store CS1N is charged to a voltage depending on a voltage difference between the potential at the input connection INN and the low-side reference potential connection VCML.

During the second period, the second pair of charge stores CS2P, CS2N is connected between the differential signal input INP, INN and the low-side reference potential connection VCML. However, the second pair of charge stores CS2P, CS2N is connected in a crossed fashion with respect to the connection of the first pair of charge stores CS1P, CS1N during the first period T1. Therefore, a voltage difference stored on the charge stores CS2P, CS2N has an opposite polarity with respect to the charge stores CS1P, CS1N. Furthermore, during the first period T1, the fourth pair of charge stores CF1P, CF1N is discharged, whereas during the second period T2, the third pair of charge stores CF2P, CF2N is discharged.

During the second period T2, the first pair of charge stores CS1P, CS1N is connected between the high-side reference potential connection VCMH and the differential input AIP, AIN of the amplifier AMP by means of the switches SW5P, SW5N, SW2P, SW2N. Furthermore, the differential input AIP, AIN of the amplifier AMP is connected to the differential output AON, AOP of the amplifier AMP via the fourth pair of charge stores CF1P, CF1N. Accordingly, the voltage difference stored on the first pair of charge stores CS1P, CS1N during the first period T1 is provided to the amplifier AMP having the capacitive feedback during the second period T2. This results in a respective differential output voltage at the differential output AON, AOP and the differential signal output OTP, OTN, respectively.

In a similar fashion, during the first period T1, the second pair of charge stores CS2P, CS2N is connected between the high-side reference potential connection VCMH and the differential input AIP, AIN and, via the third pair of charge stores CF2P, CF2N, to the differential output AON, AOP of the amplifier AMP. Accordingly, during the second period, the voltage difference stored on the second pair of charge stores CS2N, CS2P during the first period T1 is provided to the amplifier AMP, which results in a respective output voltage at a differential signal output OTP, OTN. However, because of the charging of the second pair of charge stores CS2N, CS2P in a crossed fashion, the polarity of the output signal during the second period T2 is opposite to the polarity of the output signal during the first period T1. Hence, chopping is performed by means of the alternate and crossed charging of the first and second pair of charge stores CS1P, CS1N, CS2P, CS2N.

Preferably, the charge stores of the first and the second pair of charge stores CS1P, CS1N, CS2P, CS2N have the same first capacitance value CS, whereas the charge stores of the third and the fourth pair of charge stores CF2P, CF2N, CF1P, CF1N have the same second capacitance value CF. Herein, the term "same value" is limited by production tolerances. In other words, the respective charge stores have nominally the same capacitance value. A ratio of the first capacitance value CS, which can also be called a source-side capacitance, and the second capacitance value CF, which can also be called a feedback capacitance, determines a gain G between an input voltage difference at the differential signal input INP, INN, an output voltage difference at the differential signal output OTP, OTN. This can also be expressed by G = CS/CF. Depending on the specific application, the first and the second capacitance value CS, CF can be in the order of 10 pF.

The first and the second capacitance value CS, CF can be fixed values in the amplifier arrangement in various embodiments. However, in some embodiments, the first and/or the second capacitance value CS, CF can be adjustable. For example, the third and the fourth pair of charge stores CF2P, CF2N, CF1P, CF1N can have an adjustable or programmable second capacitance value CF. For example, the respective charge stores CF1P, CF2P, CF2N, CF1N can be embodied as programmable capacitor arrays which are known in the art. By programming or adjusting the second capacitance value CF, the gain G of the amplifier arrangement is adjusted accordingly. Although not described in detail, programming or adjusting of the first capacitance value CS is also possible, also resulting in a programmable gain G of the amplifier arrangement.

FIG. 3 shows an embodiment of a measurement arrangement which is used for sensing a current flowing from or to a battery BAT. The battery BAT is connected to a ground potential connection GND at its negative side. A sensing resistor RS, which can be a shunt resistor, is connected to the positive side of the battery BAT. It should be noted that the battery BAT is shown in this embodiment as a general example for any kind of voltage source or current source. Another end of the resistor RS is connected to some other circuit which is not shown here for reasons of a better overview. However, said circuit can draw a current $I_{LOAD}$ from the battery or provide a charging current $I_{CHARGE}$ to the battery BAT, for example.

The measurement arrangement further comprises an amplifier arrangement AA which, for example, is an amplifier arrangement according to an embodiment of the arrangement shown in FIG. 1. The resistor RS is connected in between the differential signal input INP, INN of the amplifier arrangement AA. The differential signal output OTP, OTN of the amplifier arrangement AA is connected to an analog-to-digital converter AD with a differential connection. An output of the analog-to-digital converter AD is coupled to a digital dechopper DCP whose output is coupled to a digital output DOT of the measurement arrangement.

During operation of the measurement arrangement, as well the amplifier arrangement AA as the digital dechopper are operated with signals depending on a signal with a chopping frequency fc. When a current is flowing over the resistor RS from or to the battery BAT, a respective voltage drop results over the differential signal input INP, INN. With reference to FIGs. 1 and 2, said voltage drop is sensed by the amplifier arrangement AA such that an amplified and chopped analog differential signal is provided at the differential signal output OTP, OTN. The chopped output signal is converted to respective digital value in the analog-to-digital converter AD. The digital values resulting from the analog-to-digital conversion are provided to the digital dechopper DCP which performs a dechopping of the digital values and provides a dechopped digital signal at the digital output DOT. In other words, while chopping is performed in the analog domain within the amplifier arrangement AA, dechopping is performed in the digital domain within the dechopper DCP. For example, the dechopper DCP averages the digital values for the dechopping. For example, dechopping can be performed according to the following formula

$$Vout = (VT1 - VT2)/2$$

wherein Vout is the digital dechopped output value, VT1 is a digital value corresponding to the first period T1, and VT2 is a digital value corresponding to the second period T2. Hence, the opposite polarities of VT1 and VT2 are considered during dechopping.

It should be noted that absolute potentials at the resistor RS can be relatively high depending on the voltage provided by the voltage source or battery BAT. A voltage drop across the resistor RS can nevertheless be small compared to said battery voltage. By employing the switched capacitor technology within the amplifier arrangement AA, the amplifier AMP can be operated at voltage levels being significantly lower than the battery voltage. In other words, the embodiment of the measurement arrangement shown in FIG. 3 provides a precise measurement of electric voltage signals hovering around a high-voltage common mode level.

For example, in automotive battery sensing, the resistor RS can be a manganese shunt which is in this case located at a high-voltage site. The switch capacitor architecture of the amplifier arrangement provides an intrinsic chopping modulation scheme which can be used for mitigating the offset and low frequency flicker noise of an amplifier including an analog-to-digital converter. The chopper demodulation is accomplished in a digital domain, as described before. According to the embodiments described, the amplifier is not required to be built using high-voltage transistors, thus enabling a better bandwidth-noise-current trade-off. Furthermore, also the analog-to-digital converter AD can be provided in a low-voltage technology which can further reduce the costs of the measurement arrangement.

The amplifier arrangement shown in FIG. 1 can be used as a front-end amplifier for high-precision sensor interfaces with high-voltage common mode inputs.

FIG. 4 shows an embodiment of a circuit part for generating a high-side reference potential at the high-side reference potential connection VCMH. For example, the resistor RS coupled between the differential signal input INP, INN is divided into two resistors RS1, RS2 connected in series. The high-side reference potential connection VCMH is connected to the connection of these resistors RS1, RS2. Preferably, a resistance of the resistors RS1, RS2 is equal resulting in a common mode voltage at the high-side reference potential connection VCMH being basically in the middle of the potentials at the connection INP, INN. However, it is also possible to connect the high-side reference potential connection VCMH directly to one of the connections INP, INN.

FIG. 5 shows an exemplary embodiment of a circuit part for generating a low-side reference potential at the low-side reference potential connection VCML. In this embodiment, a DC/DC converter LDO is connected to the voltage source BAT which provides a positive and a negative supply voltage provided to the amplifier AMP and to an operational amplifier. For example, the DC/DC converter LDO can comprise a low dropout regulator. A series connection of resistors RL1, RL2 is connected between an output of the operational amplifier and the negative supply voltage connection, wherein the low-side reference potential connection VCML is connected to the output of the operational amplifier. The connection of the resistors RL1, RL2 is coupled to an inverting input of the operational amplifier, whereas a non-inverting input of the operational amplifier is provided with a reference voltage. Similar to the embodiment shown in FIG. 4, a resistance of the resistors RL1, RL2 preferably is equal. In any case, a common mode voltage of the low side is provided at the low-side reference potential connection VCML.

Reference list

| CS1P, ..., CF2N | charge store |
| SW1P, ..., SW12N | switch |
| AMP | amplifier |
| INP, INN | differential signal input |
| OTP, OTN | differential signal output |
| AIP, AIN | differential input |
| AON, AOP | differential output |
| VCMH, VCML | reference potential connection |
| P1, P2 | connection |
| P1A, P2A | connection |
| P1F, P2F | connection |
| BAT | voltage source |
| GND | ground potential connection |
| RS, RS1, RS2 | resistor |
| RL1, RL2 | resistor |
| AA | amplifier arrangement |
| AD | analog-to-digital converter |
| DCP | digital dechopper |
| DOT | digital output |
| LDO | DC/DC converter |

**Claims**

1. Amplifier arrangement, comprising

   - a first differential signal path coupling a differential signal input, which has two connections (INP, INN), to a differential input, which has two connections (AIP, AIN), of an amplifier (AMP), the first differential signal path comprising a first pair of charge stores (CS1P, CS1N), each charge store (CS1P, CS1N) of the first pair connected in between a first and a second pair of switches (SW1P, SW2P, SW1N, SW2N), respectively;
   - a second differential signal path coupling the differential signal input (INP, INN) to the differential input (AIP, AIN) of the amplifier (AMP) cross-coupled with respect to the first differential signal path, the second differential signal path comprising a second pair of charge stores (CS2P, CS2N), each charge store (CS2P, CS2N) of the second pair connected in between a third and a fourth pair of switches (SW3P, SW4P, SW3N, SW4N), respectively; and
   - a differential signal output (OTP, OTN) which has two connections and is coupled to a differential output, which has two connections (AON, AOP), of the amplifier (AMP) and, in a switchable manner, to the differential input (AIP, AIN) of the amplifier (AMP) by a third and a fourth pair of charge stores (CF2P, CF2N, CF1P, CF1N), respectively;
   - wherein respective first connections of the charge stores of the first and the second pair of charge stores (CS1P, CS1N, CS2P, CS2N) are coupled to a high-side reference potential connection (VCMH) in a switchable manner; and
   - wherein respective second connections of the charge stores of the first and the second pair of charge stores (CS1P, CS1N, CS2P, CS2N) are coupled to a low-side reference potential connection (VCML) in a switchable manner, wherein the amplifier arrangement is configured,
   - during a first period, to connect the first pair of charge stores (CS1P, CS1N) between either of the connections of the differential signal input (INP, INN) and the low-side reference potential connection (VCML), respectively, to connect the second pair of charge stores (CS2P, CS2N) between the high-side reference potential connection (VCMH) and either of the connections of the differential input (AIP, AIN) of the amplifier (AMP), respectively, and to connect the connections of the differential input (AIP, AIN) of the amplifier (AMP) to the respective connection of the differential output (AON, AOP) of the amplifier (AMP) via one respective charge store of the third pair of charge stores (CF2P, CF2N); and
- during a second period, to connect, in a cross-coupled fashion, the second pair of charge stores (CS2P, CS2N) between either of the connections of the differential signal input (INP, INN) and the low-side reference potential connection (VCML), respectively, to connect the first pair of charge stores (CS1P, CS1N) between the high-side reference potential connection (VCMH) and either of the connections of the differential input (AIP, AIN) of the amplifier (AMP), respectively, and to connect the connections of the differential input (AIP, AIN) of the amplifier (AMP) to the respective connection of the differential output (AON, AOP) of the amplifier (AMP) via one respective charge store of the fourth pair of charge stores (CF1P, CF1N).

2. Amplifier arrangement according to claim 1, which is configured, during the first period, to discharge the charge stores of the fourth pair of charge stores (CF1P, CF1N) and, during the second period, to discharge the charge stores of the third pair of charge stores (CF2P, CF2N).

3. Amplifier arrangement according to claims 1 or 2, wherein the charge stores of the first and the second pair of charge stores (CS1P, CS1N, CS2P, CS2N) have the same first capacitance value (CS), and the charge stores of the third and the fourth pair of charge stores (CF2P, CF2N, CF1P, CF1N) have the same second capacitance value (CF).

4. Amplifier arrangement according to claim 3, wherein the first and/or the second capacitance value (CS, CF) is adjustable.

5. Measurement arrangement with an amplifier arrangement according to one of claims 1 to 4 which is configured to be operated with switching signals based on a signal with a chopping frequency, the measurement arrangement further comprising

    - an analog to digital converter (AD) coupled to the differential signal output (OTP, OTN); and
    - a digital dechopper (DCP) coupled to the analog to digital converter (AD) for dechopping digital values provided by the analog to digital converter (AD) as a function of the signal with the chopping frequency.

6. Measurement arrangement according to claim 5, wherein the dechopper (DCP) is configured to perform the dechopping by averaging the digital values.

7. Signal processing method, comprising

    - providing a differential input signal at a differential signal input, which has two connections (INP, INN);
    - during a first period, connecting a first pair of charge stores (CS1P, CS1N) between either of the connections of the differential signal input (INP, INN) and a low-side reference potential connection (VCML), respectively;
    - during the first period, connecting a second pair of charge stores (CS2P, CS2N) between a high-side reference potential connection (VCMH) and either of two connections of a differential input (AIP, AIN) of an amplifier (AMP), respectively;
    - during the first period, connecting two connections of a differential output (AON, AOP) of the amplifier (AMP) to a respective connection of the differential input (AIP, AIN) of the amplifier (AMP) via one respective charge store of a third pair of charge stores (CF2P, CF2N);
    - during a second period, connecting the second pair of charge stores (CS2P, CS2N) between either of the connections of the differential signal input (INP, INN) and the low-side reference potential connection (VCML), respectively, in a cross-coupled fashion with respect to the first pair of charge stores (CS1P, CS1N);
    - during the second period, connecting the first pair of charge stores (CS1P, CS1N) between the high-side reference potential connection (VCMH) and either of the connections of the differential input (AIP, AIN) of the amplifier (AMP), respectively;
    - during the second period, connecting the connections of the differential input (AIP, AIN) of the amplifier (AMP) to the respective connection of the differential output (AON, AOP) of the amplifier (AMP) via one respective charge store of a fourth pair of charge stores (CF1P, CF1N); and
    - providing an output signal at the differential output (AON, AOP) of the amplifier (AMP) to a differential signal output (OTP, OTN).

8. Signal processing method according to claim 7, further comprising

    - during the first period, discharging the charge stores of the fourth pair of charge stores (CF1P, CF1N); and
    - during the second period, discharging the charge stores of the third pair of charge stores (CF2P, CF2N).

9. Signal processing method according to claim 7 or 8, wherein the charge stores of the first and the second pair of charge stores (CS1P, CS1N, CS2P, CS2N) have the same first capacitance value (CS), and the charge stores of the third and the fourth pair of charge stores (CF2P, CF2N, CF1P, CF1N) have the same second capacitance value (CF).

10. Signal processing method according to claim 9, further comprising adjusting of the first and/or the second capacitance value (CS, CF).

11. Signal processing method according to one of claims 7 to 10, wherein clocking signals determining the first and the second period are based on a signal with a chopping frequency, the method further comprising

   - analog to digital conversion of the output signal; and
   - dechopping, as a function of the signal with the chopping frequency, digital values resulting from the analog to digital conversion.

12. Signal processing method according to claim 11, wherein dechopping comprises averaging the digital values.


**Patentansprüche**

1. Verstärkeranordnung, Folgendes umfassend:

   - einen ersten Differenzsignalpfad, der einen über zwei Anschlüsse (INP, INN) verfügenden Differenzsignaleingang auf einen über zwei Anschlüsse (AIP, AIN) verfügenden Differenzeingang eines Verstärkers (AMP) aufschaltet, wobei der erste Differenzsignalpfad ein erstes Paar Ladungsspeicher (CS1P, CS1N) umfasst, wobei jeder Ladungsspeicher (CS1P, CS1N) des ersten Paars zwischen einem ersten bzw. zweiten Paar von Schaltern (SW1P, SW2P, SW1N, SW2N) zwischengeschaltet ist;
   - einen zweiten Differenzsignalpfad, der den Differenzsignaleingang (INP, INN) auf den Differenzeingang (AIP, AIN) des Verstärkers (AMP) kreuzgekoppelt im Hinblick auf den ersten Differenzsignalpfad aufschaltet, wobei der zweite Differenzsignalpfad ein zweites Paar Ladungsspeicher (CS2P, CS2N) umfasst, wobei jeder Ladungsspeicher (CS2P, CS2N) des zweiten Paars zwischen einem dritten bzw. vierten Paar von Schaltern (SW3P, SW4P, SW3N, SW4N) zwischengeschaltet ist; und
   - einen Differenzsignalausgang (OTP, OTN), der zwei Anschlüsse hat und auf einen über zwei Anschlüsse (AON, AOP) verfügenden Differenzausgang auf den Verstärker (AMP) und auf eine schaltbare Weise auf den Differenzeingang (AIP, AIN) des Verstärkers (AMP) durch ein drittes bzw. viertes Paar Ladungsspeicher (CF2P, CF2N, CF1P, CF1N) aufgeschaltet ist,
   - wobei jeweilige erste Anschlüsse der Ladungsspeicher des ersten und zweiten Paars Ladungsspeicher (CS1P, CS1N, CS2P, CS2N) auf eine schaltbare Weise auf einen hochspannungsseitigen Bezugspotentialanschluss (VCMH) aufgeschaltet sind; und
   - wobei jeweilige zweite Anschlüsse der Ladungsspeicher des ersten und zweiten Paars Ladungsspeicher (CS1P, CS1N, CS2P, CS2N) auf eine schaltbare Weise auf einen niederspannungsseitigen Bezugspotentialanschluss (VCML) aufgeschaltet sind, wobei die Verstärkeranordnung dazu ausgelegt ist,
   - während eines ersten Zeitraums das erste Paar Ladungsspeicher (CS1P, CS1N) zwischen jeweils einem der Anschlüsse des Differenzsignaleingangs (INP, INN) und dem niederspannungsseitigen Bezugspotentialanschluss (VCML) zwischenzuschalten, das zweite Paar Ladungsspeicher (CS2P, CS2N) zwischen dem hochspannungsseitigen Bezugspotentialanschluss (VCMH) und jeweils einem der Anschlüsse des Differenzeingangs (AIP, AIN) des Verstärkers (AMP) zwischenzuschalten, und die Anschlüsse des Differenzeingangs (AIP, AIN) des Verstärkers (AMP) über einen jeweiligen Ladungsspeicher des dritten Paars Ladunsspeicher (CF2P, CF2N) auf den jeweiligen Anschluss des Differenzausgangs (AON, AOP) des Verstärkers (AMP) aufzuschalten; und
   - während eines zweiten Zeitraums das zweite Paar Ladungsspeicher (CS2P, CS2N) auf kreuzgekoppelte Weise zwischen jeweils einem der Anschlüsse des Differenzsignaleingangs (INP, INN) und dem niederspannungsseitigen Bezugspotentialanschluss (VCML) zwischenzuschalten, das erste Paar Ladungsspeicher (CS1P, CS1N) zwischen dem hochspannungsseitigen Bezugspotentialanschluss (VCMH) und jeweils einem der Anschlüsse des Differenzeingangs (AIP, AIN) des Verstärkers (AMP) zwischenzuschalten, und die Anschlüsse des Differenzeingangs (AIP, AIN) des Verstärkers (AMP) über einen jeweiligen Ladungsspeicher des vierten Paars Ladungsspeicher (CF1P, CF1N) auf den jeweiligen Anschluss des Differenzausgangs (AON, AOP) des Verstärkers (AMP) aufzuschalten.

2. Verstärkeranordnung nach Anspruch 1, die dazu ausgelegt ist, während des ersten Zeitraums die Ladungsspeicher des vierten Paars Ladungsspeicher (CF1P, CF1N) zu entladen, und während des zweiten Zeitraums die Ladungsspeicher des dritten Paars Ladungsspeicher (CF2P, CF2N) zu entladen.

3. Verstärkeranordnung nach Anspruch 1 oder 2, wobei die Ladungsspeicher des ersten und zweiten Paars Ladungsspeicher (CS1P, CS1N, CS2P, CS2N) denselben ersten Kapazitätswert (CS) haben, und die Ladungsspeicher des dritten und vierten Paars Ladungsspeicher (CF2P, CF2N, CF1P, CF1N) denselben zweiten Kapazitätswert (CF) haben.

4. Verstärkeranordnung nach Anspruch 3, wobei der erste und/oder der zweite Kapazitätswert (CS, CF) einstellbar ist/sind.

5. Messanordnung mit einer Verstärkeranordnung nach einem der Ansprüche 1 bis 4, die dazu ausgelegt ist, mit Schaltsignalen auf Grundlage eines Signals mit einer Zerhackfrequenz betrieben zu werden, wobei die Messanordnung darüber hinaus umfasst

- einen Analog/Digital-Wandler (AD), der auf den Differenzsignalausgang (OTP, OTN) aufgeschaltet ist; und
- einen digitalen Enthacker (DCP), der auf den Analog/Digital-Wandler (AD) aufgeschaltet ist, um digitale Werte, die durch den Analog/Digital-Wandler (AD) bereitgestellt werden, in Abhängigkeit von dem Signal mit der Zerhackfrequenz zu enthacken.

6. Messanordnung nach Anspruch 5, wobei der Enthacker (DCP) dazu ausgelegt ist, das Enthacken durch eine Mittelwertbildung der digitalen Werte zu enthacken.

7. Signalverarbeitungsverfahren, Folgendes umfassend:

- Bereitstellen eines Differenzeingangssignals an einem Differenzsignaleingang, der zwei Anschlüsse (INP, INN) hat;
- während eines ersten Zeitraums Zwischenschalten eines ersten Paars Ladungsspeicher (CS1P, CS1N) zwischen jeweils einem der Anschlüsse des Differenzsignaleingangs (INP, INN) und einem niederspannungsseitigen Bezugspotentialanschluss (VCML);
- während des ersten Zeitraums Zwischenschalten eines zweiten Paars Ladungsspeicher (CS2P, CS2N) zwischen jeweils einem hochspannungsseitigen Bezugspotentialanschluss (VCMH) und einem von zwei Anschlüssen eines Differenzeingangs (AIP, AIN) eines Verstärkers (AMP);
- während des ersten Zeitraums Aufschalten von zwei Anschlüssen eines Differenzausgangs (AON, AOP) des Verstärkers (AMP) über einen jeweiligen Ladungsspeicher des dritten Paars Ladungsspeicher (CF2P, CF2N) auf einen jeweiligen Anschluss des Differenzeingangs (AIP, AIN) des Verstärkers (AMP);
- während eines zweiten Zeitraums Zwischenschalten des zweiten Paars Ladungsspeicher (CS2P, CS2N) zwischen jeweils einem der Anschlüsse des Differenzsignaleingangs (INP, INN) und dem niederspannungsseitigen Bezugspotentialanschluss (VCML), und zwar auf eine kreuzgekoppelte Weise im Hinblick auf das erste Paar Ladungsspeicher (CS1P, CS1N);
- während des zweiten Zeitraums Zwischenschalten des ersten Paars Ladungsspeicher (CS1P, CS1N) zwischen dem hochspannungsseitigen Bezugspotentialanschluss (VCMH) und jeweils einem der Anschlüsse des Differenzeingangs (AIP, AIN) des Verstärkers (AMP);
- während des zweiten Zeitraums Aufschalten der Anschlüsse des Differenzeingangs (AIP, AIN) des Verstärkers (AMP) über einen jeweiligen Ladungsspeicher eines vierten Paars Ladungsspeicher (CF1P, CF1N) auf den jeweiligen Anschluss des Differenzausgangs (AON, AOP) des Verstärkers (AMP); und
- Bereitstellen eines Ausgangssignals am Differenzausgang (AON, AOP) des Verstärkers (AMP) an einen Differenzsignalausgang (OTP, OTN).

8. Signalverarbeitungsverfahren nach Anspruch 7, darüber hinaus umfassend:

- während des ersten Zeitraums Entladen der Ladungsspeicher des vierten Paars Ladungsspeicher (CF1P, CF1N); und
- während des zweiten Zeitraums Entladen der Ladungsspeicher des dritten Paars Ladungsspeicher (CF2P, CF2N).

9. Signalverarbeitungsverfahren nach Anspruch 7 oder 8, wobei die Ladungsspeicher des ersten und zweiten Paars Ladungsspeicher (CS1P, CS1N, CS2P, CS2N) denselben ersten Kapazitätswert (CS) haben, und die Ladungsspeicher des dritten und vierten Paars Ladungsspeicher (CF2P, CF2N, CF1P, CF1N) denselben zweiten Kapazitätswert (CF) haben.

10. Signalverarbeitungsverfahren nach Anspruch 9, darüber hinaus umfassend, den ersten und/oder zweiten Kapazitätswert (CS, CF) einzustellen.

11. Signalverarbeitungsverfahren nach einem der Ansprüche 7 bis 10, wobei Taktvorgabesigale, die den ersten und zweiten Zeitraum bestimmen, auf einem Signal mit einer Zerhackfrequenz beruhen, wobei das Verfahren darüber hinaus umfasst:

- eine Analog/Digital-Umwandlung des Ausgangssignals; und
- Enthacken von sich aus der Analog/Digital-Umwandlung ergebenden digitalen Werten in Abhängigkeit des Signals mit der Zerhackfrequenz.

12. Signalverarbeitungsverfahren nach Anspruch 11, wobei das Enthacken eine Mittelwertbildung der digitalen Werte umfasst.

**Revendications**

1. Dispositif amplificateur, comprenant

- un premier chemin de signal différentiel couplant une entrée de signal différentiel, laquelle a deux connexions (INP, INN), à une entrée différentielle, laquelle a deux connexions (AIP, AIN), d'un amplificateur (AMP), le premier chemin de signal différentiel comprenant une première paire d'accumulateurs de charge (CS1P, CS1N), chaque accumulateur de charge (CS1P, CS1N) de la première paire étant connecté entre une première et une deuxième paire d'interrupteurs (SW1P, SW2P, SW1N, SW2N), respectivement ;
- un deuxième chemin de signal différentiel couplant l'entrée de signal différentiel (INP, INN) à l'entrée différentielle (AIP, AIN) de l'amplificateur (AMP) selon un couplage transversal par rapport au premier chemin de signal différentiel, le deuxième chemin de signal différentiel comprenant une deuxième paire d'accumulateurs de charge (CS2P, CS2N), chaque accumulateur de charge (CS2P, CS2N) de la deuxième paire étant connecté entre une troisième et une quatrième paire d'interrupteurs (SW3P, SW4P, SW3N, SW4N), respectivement ; et
- une sortie de signal différentiel (OTP, OTN) qui a deux connexions et est couplée à une sortie différentielle, laquelle a deux connexions (AON, AOP), de l'amplificateur (AMP) et, de manière commutable, à l'entrée différentielle (AIP, AIN) de l'amplificateur (AMP) par une troisième et une quatrième paire d'accumulateurs de charge (CF2P, CF2N, CF1P, CF1N), respectivement ;
- où des premières connexions respectives des accumulateurs de charge de la première et de la deuxième paire d'accumulateurs de charge (CS1P, CS1N, CS2P, CS2N) sont couplées à une connexion de potentiel de référence côté haut (VCMH) de manière commutable ; et

- où des deuxièmes connexions respectives des accumulateurs de charge de la première et de la deuxième paire d'accumulateurs de charge (CS1P, CS1N, CS2P, CS2N) sont couplées à une connexion de potentiel de référence côté bas (VCML) de manière commutable, le dispositif amplificateur étant configuré,
- pendant une première période, pour connecter la première paire d'accumulateurs de charge (CS1P, CS1N) entre l'une ou l'autre des connexions de l'entrée de signal différentiel (INP, INN) et la connexion de potentiel de référence côté bas (VCML), respectivement, pour connecter la deuxième paire d'accumulateurs de charge (CS2P, CS2N) entre la connexion de potentiel de référence côté haut (VCMH) et l'une ou l'autre des connexions de l'entrée différentielle (AIP, AIN) de l'amplificateur (AMP), respectivement, et pour connecter les connexions de l'entrée différentielle (AIP, AIN) de l'amplificateur (AMP) à la connexion respective de la sortie différentielle (AON, AOP) de l'amplificateur (AMP) via un accumulateur de charge respectif de la troisième paire d'accumulateurs de charge (CF2P, CF2N) ; et
- pendant une deuxième période, pour connecter, selon un couplage transversal, la deuxième paire d'accumulateurs de charge (CS2P, CS2N) entre l'une ou l'autre des connexions de l'entrée de signal différentiel (INP, INN) et la connexion de potentiel de référence côté bas (VCML), respectivement, pour connecter la première paire d'accumulateurs de charge (CS1P, CS1N) entre la connexion de potentiel de référence côté haut (VCMH) et l'une ou l'autre des connexions de l'entrée différentielle (AIP, AIN) de l'amplificateur (AMP), respectivement, et pour connecter les connexions de l'entrée différentielle (AIP, AIN) de l'amplificateur (AMP) à la connexion respective de la sortie différentielle (AON, AOP) de l'amplificateur (AMP) via un accumulateur de charge respectif de la quatrième paire d'accumulateurs de charge (CF1P, CF1N).

2. Dispositif amplificateur selon la revendication 1, qui est configuré, pendant la première période, pour décharger les accumulateurs de charge de la quatrième paire d'accumulateurs de charge (CF1P, CF1N) et, pendant la deuxième période, pour décharger les accumulateurs de charge de la troisième paire d'accumulateurs de charge (CF2P, CF2N) .

3. Dispositif amplificateur selon la revendication 1 ou 2, où les accumulateurs de charge de la première et de la deuxième paire d'accumulateurs de charge (CS1P, CS1N, CS2P, CS2N) ont la même première valeur de capacité (CS), et les accumulateurs de charge de la troisième et de la quatrième paire d'accumulateurs de charge (CF2P, CF2N, CF1P, CF1N) ont la même deuxième valeur de capacité (CF).

4. Dispositif amplificateur selon la revendication 3, où la première et/ou la deuxième valeur de capacité (CS, CF) est/sont réglable(s).

5. Dispositif de mesure doté d'un dispositif amplificateur selon l'une des revendications 1 à 4, qui est configuré pour être exploité avec des signaux de commutation sur la base d'un signal ayant une fréquence de hachage, le dispositif de mesure comprenant en outre

    - un convertisseur analogique-numérique (AD) couplé à la sortie de signal différentiel (OTP, OTN) ; et
    - un déhacheur numérique (DCP) couplé au convertisseur analogique-numérique (AD) pour déhacher des valeurs numériques, fournies par le convertisseur analogique-numérique (AD), en fonction du signal ayant la fréquence de hachage.

6. Dispositif de mesure selon la revendication 5, où le déhacheur (DCP) est configuré pour effectuer le déhachage en faisant la moyenne des valeurs numériques.

7. Procédé de traitement de signal, comprenant

    - la fourniture d'un signal d'entrée différentiel à une entrée de signal différentiel, laquelle a deux connexions (INP, INN) ;
    - pendant une première période, le fait de connecter une première paire d'accumulateurs de charge (CS1P, CS1N) entre l'une ou l'autre des connexions de l'entrée de signal différentiel (INP, INN) et une connexion de potentiel de référence côté bas (VCML), respectivement ;
    - pendant la première période, le fait de connecter une deuxième paire d'accumulateurs de charge (CS2P, CS2N) entre une connexion de potentiel de référence côté haut (VCMH) et l'une ou l'autre de deux connexions d'une entrée différentielle (AIP, AIN) d'un amplificateur (AMP), respectivement ;
    - pendant la première période, le fait de connecter deux connexions d'une sortie différentielle (AON, AOP) de l'amplificateur (AMP) à une connexion respective de l'entrée différentielle (AIP, AIN) de l'amplificateur (AMP) via un accumulateur de charge respectif d'une troisième paire d'accumulateurs de charge (CF2P, CF2N) ;
    - pendant une deuxième période, le fait de connecter la deuxième paire d'accumulateurs de charge (CS2P, CS2N) entre l'une ou l'autre des connexions de l'entrée de signal différentiel (INP, INN) et la connexion de potentiel de référence côté bas (VCML), respectivement, selon un couplage transversal par rapport à la première paire d'accumulateurs de charge (CS1P, CS1N) ;
    - pendant la deuxième période, le fait de connecter la première paire d'accumulateurs de charge (CS1P, CS1N) entre la connexion de potentiel de référence côté haut (VCMH) et l'une ou l'autre des connexions de l'entrée différentielle (AIP, AIN) de l'amplificateur (AMP), respectivement ;
    - pendant la deuxième période, le fait de connecter les connexions de l'entrée différentielle (AIP, AIN) de l'amplificateur (AMP) à la connexion respective de la sortie différentielle (AON, AOP) de l'amplificateur (AMP) via un accumulateur de charge respectif d'une quatrième paire d'accumulateurs de charge (CF1P, CF1N) ; et
    - la fourniture d'un signal de sortie à la sortie différentielle (AON, AOP) de l'amplificateur (AMP) vers une sortie de signal différentiel (OTP, OTN).

8. Procédé de traitement de signal selon la revendication 7, comprenant en outre

    - pendant la première période, le fait de décharger les accumulateurs de charge de la quatrième paire d'accumulateurs de charge (CF1P, CF1N) ; et
    - pendant la deuxième période, le fait de décharger les accumulateurs de charge de la troisième paire d'accumulateurs de charge (CF2P, CF2N).

9. Procédé de traitement de signal selon la revendication 7 ou 8, où les accumulateurs de charge de la première et de la deuxième paire d'accumulateurs de charge (CS1P, CS1N, CS2P, CS2N) ont la même première valeur de capacité (CS), et les accumulateurs de charge de la troisième et de la quatrième paire d'accumulateurs de charge (CF2P, CF2N, CF1P, CF1N) ont la même deuxième valeur de capacité (CF).

10. Procédé de traitement de signal selon la revendication 9, comprenant en outre le réglage de la première et/ou de la deuxième valeur de capacité (CS, CF).

11. Procédé de traitement de signal selon l'une des revendications 7 à 10, où des signaux d'horloge déterminant la première et la deuxième période sont basés sur un signal ayant une fréquence de hachage, le procédé comprenant en outre

    - la conversion analogique-numérique du signal de sortie ; et
- le déhachage, comme fonction du signal ayant la fréquence de hachage, de valeurs numériques résultant de la conversion analogique-numérique.

**12.** Procédé de traitement de signal selon la revendication 11, où le déhachage comprend le fait d'effectuer la moyenne des valeurs numériques.

Fig 1

EP 2 173 031 B1

Fig 2

Fig 3

Fig 4

Fig 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5498984 A
- US 6621259 B
- US 6617838 B1